# EUROPÄISCHE PATENTSCHRIFT

(11) **EP 0 688 474 B1**
(45) Veröffentlichungstag und Bekanntmachung des Hinweises auf die Patenterteilung: **21.01.1998**
(21) Anmeldenummer: 94908968.4
(22) Anmeldetag: 09.03.1994
(51) Int. Cl.: H03F 1/30

(54) **SCHALTUNGSANORDNUNG ZUM VERSTÄRKEN EINES NIEDRIGEN GLEICHSPANNUNGSSIGNALS**
CIRCUIT FOR AMPLIFYING A WEAK DIRECT VOLTAGE SIGNAL
CIRCUIT D'AMPLIFICATION D'UN FAIBLE SIGNAL DE TENSION CONTINUE

(30) Priorität: 09.03.1993 DE 4308229
(43) Veröffentlichungstag der Anmeldung: 27.12.1995
(73) Patentinhaber: SIEMENS AKTIENGESELLSCHAFT, 80333 München (DE)
(72) Erfinder: SCHULZ, Winfried, D-12105 Berlin (DE)
(86) Internationale Anmeldenummer: DE9400261
(87) Internationale Veröffentlichungsnummer: WO9421033

(56) Entgegenhaltungen:
- EP-A- 0 148 685
- US-A- 4 068 182
- REVIEW OF SCIENTIFIC INSTRUMENTS., Bd.59, Nr.7, Juli 1988, NEW YORK US Seiten 1241 - 1243 R.C.S. FREIRE ET AL 'DC AMPLIFIER WITH AUTO-ZEROING OF THERMAL DRIFT'

## Beschreibung

Die Erfindung bezieht sich auf eine Schaltungsanordnung zum Verstärken eines niedrigen Gleichspannungssignals mit einem Gleichspannungsverstärker, der durch eine Schalteinrichtung mit einem periodisch arbeitenden Kurzschließer an seinen Eingangsanschlüssen periodisch entweder mit dem Gleichspannungssignal oder einem Referenzsignal versorgt wird, und mit einer dem Gleichspannungsverstärker nachgeordneten Meßwertverarbeitungseinrichtung, die eine bei dem Referenzsignal am Eingang des Gleichspannungsverstärkers sich ergebende Ausgangsspannung des Gleichspannungsverstarkers speichert und von einer sich bei am Eingang des Gleichspannungsverstärkers anliegenden Gleichspannungssignal ergebenden Ausgangsspannung des Gleichspannungsverstärkers subtrahiert.

Eine Schaltungsanordnung dieser Art ist aus der Zeitschrift "Review of Scientific Instruments", 59 (1988), Juli, Nr. 7, Seiten 1241 bis 1243 bekannt. Bei dieser Anordnung ist ein Gleichspannungsverstärker eingangsseitig durch einen Kurzschließer von der zu messenden Spannung abtrennbar und auf Masse legbar. Ist der Gleichspannungsverstärker eingangsseitig kurzgeschlossen, dann ist seine Ausgangsspannung nur vom Offset abhängig; eine sich in diesem Schaltzustand ergebende Ausgangsspannung des Gleichspannungsverstärkers wird in einer zusätzlichen Schaltungseinheit gespeichert. Liegt der Gleichspannungsverstärker in einem nachfolgenden Meßzeitraum wieder an der zu messenden Gleichspannung, dann wird von der sich dann ergebenden Ausgangsspannung die der Offsetspannung entsprechende, gespeicherte Ausgangsspannung subtrahiert.

Der Erfindung liegt daher die Aufgabe zugrunde, eine Schaltungsanordnung der oben beschriebenen Art so zu verbessern, daß die verstärkte Gleichspannung weitestgehend dem zu verstärkenden, niedrigen Gleichspannungssignal entspricht.

Zur Lösung dieser Aufgabe liegt bei einer Schaltungsanordnung der angegebenen Art erfindungsgemäß, bei einem von einem Signal an der Ausgangsdiagonale einer Meßbrücke gebildeten zu verstärkenden Gleichspannungssignal, mit dem periodisch arbeitenden Kurzschließer in Reihe ein stets geschlossenes Schaltelement der Schalteinrichtung an den Eingangsanschlüssen des Gleichspannungsverstärkers, und der gemeinsame Verbindungspunkt von Kurzschließer und stets geschlossenem Schaltelement ist sowohl mit einem Kontakt eines weiteren Schaltelementes der Schalteinrichtung als auch mit einem Anschlußpunkt der Ausgangsdiagonale der Meßbrücke verbunden; der andere Kontakt des weiteren Schaltelementes ist einerseits mit dem anderen Schaltungspunkt der Ausgangsdiagonale der Meßbrücke und andererseits über ein zusätzliches Schaltelement der Schalteinrichtung mit dem mit dem Kurzschließer verbundenen Eingangsanschluß des Gleichspannungsverstärkers verbunden.

Der wesentliche Vorteil der erfindungsgemäßen Schaltungsanordnung besteht darin, daß sich der Einfluß von nicht vermeidbaren Widerständen der einzelnen Schaltelemente der Schalteinrichtung kompensieren läßt; als Schalteinrichtung kommen nämlich bevorzugt elektronisch arbeitende Schalteinrichtungen in Frage, deren einzelne Schaltelemente selbst bei einer Ausführung in HCMOS-Technik in geschlossenem Zustand einen Innenwiderstand zwischen 100 und 200 Ω aufweisen. Dieser Innenwiderstand würde ohne die erfinderische Lösung zu einer nicht zu vernachlässigenden Abhängigkeit der Spannung am Kurzschließer von der Höhe der Spannung an der Ausgangsdiagonale der Meßbrücke führen, wodurch zwangsläufig Meßfehler eintreten. Bei der erfindungsgemäßen Schaltungsanordnung hat dagegen die Höhe der Spannung an der Ausgangsdiagonale der Meßbrücke keinen Einfluß mehr auf den Nullzustand, und es ergibt sich demzufolge keine Gleichtaktänderung mehr.

Zur Erläuterung der Erfindung ist in der
- Figur: ein Ausführungsbeispiel einer Schaltungsanordnung zum Verstärken eines niedrigen Gleichspannungssignals mit einem Kurzschließer am Eingang des Gleichspannungsverstärkers wiedergegeben.

In der dargestellten Schaltungsanordnung wird von einer Meßbrücke 20, die an einer Spannung U liegt, an einer von Schaltungspunkten 21 und 22 gebildeten Ausgangsdiagonale ein zu verstärkendes Gleichspannungssignal U_{G} erzeugt.Die Ausgangsdiagonale 21-22 der Meßbrücke 20 ist über Widerstände 23 und 24 mit Eingangsanschlüssen 26 und 27 eines Gleichspannungsverstärkers 25 verbunden. Dazwischen ist eine Schalteinrichtung 40 angeordnet, die zwischen den Eingangsanschlüssen 26 und 27 in Reihe mit einem periodisch arbeitenden Kurzschließer 41 ein stets geschlossenes Schaltelement 42 enthält. Widerstände 43 und 44 symbolisieren die Innenwiderstände des Kurzschließers 41 und des stest geschlossenen Schaltelementes 42, weil die gesamte Schalteinrichtung vorzugsweise in HCMOS-Technik ausgeführt ist. Ein Verbindungspunkt 45 zwischen dem Kurzschließer 41 und dem stets geschlossenen Schaltelement 42 ist mit einem Kontakt 46 eines weiteren Schaltelementes 47 der Schalteinrichtung 40 verbunden sowie mit dem Anschlußpunkt 22 der Ausgangsdiagonale der Meßbrücke 20. Der andere Kontakt 48 des weiteren Schaltelementes 47 ist einerseits mit dem anderen Schaltungspunkt 21 der Ausgangsdiagonale der Meßbrücke 20 und andererseits über ein zusätzliches Schaltelement 49 der Schalteinrichtung 40 mit dem Eingangsanschluß 26 verbunden. Die Widerstände 50 und 51 bezeichnen die Ersatzwiderstände der Schaltelemente 47 und 49.

Am Ausgang 31 des Gleichspannungsverstärkers 25 ist eine Meßwertverarbeitungseinrichtung 32 angeschlossen, die eingangsseitig einen Analog-Digital-Wandler 33 enthält. Diesem Analog-Digital-Wandler 33 ist ein Mikroprozessor 34 nachgeordnet.

Die dargestellte Schaltungsanordnung arbeitet in der Weise, daß im Meßzustand neben dem stets geschlossenen Schaltelement 42 auch das zusätzliche Schaltelement 49 geschlossen ist, während das weitere Schaltelement 47 und der Kurzschließer 41 geöffnet sind. Beim Umschalten auf das Referenzsignal mit dem Werte Null (Kurzschluß der Eingangsanschlüsse 26 und 27) sind neben dem stets geschlossenen Schaltelement 42 der Kurzschließer 41 und das weitere Schaltelement 47 geschlossen; nur das zusätzliche Schaltelement 49 ist geöffnet. Diese Wirkungsweise bringt es mit sich, daß das stets geschlossene Schaltelement 42 mit seinem Innenwiderstand 44 entweder den Innenwiderstand des zusätzlichen Schaltelementes 49 oder den Innenwiderstand 43 des Kurzschließers 41 symmetriert. In diesem "Nullzustand" wird der Eingang des Verstärkers 25 also durch das zusätzliche Schaltelement 49 von der Ausgangsdiagonale 21-22 der Meßbrücke 20 abgetrennt, durch den Kurzschließer 41 kurzgeschlossen und durch das weitere Schaltelement 47 auf das Potential der Mitte der Meßbrücke 20 gesetzt. Die Höhe der Spannung an der Ausgangsdiagonale 21-22 hat daher keinen Einfluß mehr auf den Nullzustand, und es tritt auch praktisch keine Gleichtaktänderung mehr auf.

Ergibt sich im "Nullzustand" am Ausgang 31 des Gleichspannungsverstärkers 25 bzw. am Ausgang des Analog-Digital-Wandlers 33 ein Signal, dann wird dieses Signal als Nullwert im Mikroprozessor 34 gespeichert. Wird danach der Meßzustand hergestellt, gelangt die Spannung U_{G} an der Ausgangsdiagonale 21-22 der Meßbrücke 20 an die Eingangsanschlüsse 26 und 27 des Gleichspannungsverstärkers 25 und hinter dem Analog-Digital-Wandler 33 als (verstärkter) Digitalwert in den Mikroprozessor 34. Dieser ermittelt unter Berücksichtigung des vorher gespeicherten Nullwertes die tatsächliche Höhe der aus der Gleichspannung U_{G} durch Verstärkung hervorgerufenen Meßgröße mit relativ großer Genauigkeit. Das verstärkte Gleichspannungssignal kann gegebenenfalls nach Digital-Analog-Rückwandlung an einem Ausgang 35 gemessen werden.

In vorteilhafter Weise ist die Schalteinrichtung so ausgewählt, daß sie den Kurzschließer und die drei weiteren Schaltelemente in einem Gehäuse enthält, wodurch die Innenwiderstände der Schaltelemente sich mit der Umgebungstemperatur in gleicher Weise ändern; der Einfluß der Umgebungstemperatur wird dadurch optimal ausgeglichen.

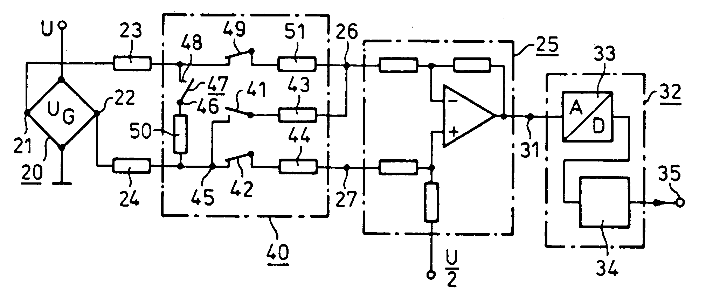

## Patentansprüche

1. Schaltungsanordnung zum Verstärken eines niedrigen Gleichspannungssignals (U_{G}) mit einem Gleichspannungsverstärker (25), der durch eine Schalteinrichtung (40) mit einem periodisch arbeitenden Kurzschließer (41) an seinen Eingangsanschlüssen (26,27) periodisch entweder mit dem Gleichspannungssignal (U_{G}) oder einem Referenzsignal versorgt wird, und mit einer dem Gleichspannungsverstärker (25) nachgeordneten Meßwertverarbeitungseinrichtung (32), die eine bei dem Referenzsignal am Eingang (26,27) des Gleichspannungsverstärkers (25) sich ergebende Ausgangsspannung des Gleichspannungsverstärkers (25) speichert und von einer sich bei am Eingang (26,27) des Gleichspannungsverstärkers (25) anliegenden Gleichspannungssignal (U_{G}) ergebenden Ausgangsspannung des Gleichspannungsverstärkers (25) subtrahiert,
**dadurch gekennzeichnet**, daß das zu verstärkende Gleichspannungssignal (U_{G}) von einem Signal an der Ausgangsdiagonale (21-22) einer Meßbrücke (20) gebildet wird, mit dem periodisch arbeitenden Kurzschließer (41) in Reihe ein stets geschlossenes Schaltelement (42) der Schalteinrichtung (40) an den Eingangsanschlüssen (26,27) des Gleichspannungsverstärkers (25) liegt,
daß der gemeinsame Verbindungspunkt (45) von Kurzschließer (41) und stets geschlossenem Schaltelement (42) sowohl mit einem Kontakt (46) eines weiteren Schaltelementes (47) der Schalteinrichtung (40) als auch mit einem Anschlußpunkt (22) der Ausgangsdiagonale (21-22) der Meßbrücke (20) verbunden ist und
daß der andere Kontakt (48) des weiteren Schaltelementes (47) einerseits mit dem anderen Schaltungspunkt (21) der Ausgangsdiagonale (21-22) der Meßbrücke (20 und andererseits über ein zusätzliches Schaltelement (49) der Schalteinrichtung (40) mit dem mit dem Kurzschließer (41) verbundenen Eingangsanschluß (26) des Gleichspannungsverstärkers (25) verbunden ist.

2. Schaltungsanordnung nach Anspruch 1,
**dadurch gekennzeichnet**, daß
daß dem Gleichspannungsverstärker (25) ein Analog-Digital-Wandler (33) nachgeordnet ist, dem ein Mikroprozessor (34) nachgeschaltet ist.

## Claims

1. A circuit arrangement for amplifying a low d.c. voltage signal (U_{G}) comprising a d.c. voltage amplifier (25) which, by a switching device (40) with a periodically operating short-circuiter (41), is supplied at its input terminals (26, 27) periodically either with the d.c. voltage signal (U_{G}) or with a reference signal, and comprising a measured value processing device (32) which is arranged downstream of the d.c. voltage amplifier (25) and which stores an output voltage of the d.c. voltage amplifier (25) which occurs when the reference signal is applied to the input (26, 27) of the d.c. voltage amplifier (25), and subtracts said output voltage from an output voltage of the d.c. voltage amplifier (25) which occurs when the d.c. voltage signal (U_{G}) is applied to the input (26, 27) of the d.c. voltage amplifier (25), characterised in that the d.c. voltage signal (U_{G}) to be amplified is formed by a signal across the output diagonal (21-22) of a measuring bridge (20), that in series with the periodically operating short-circuiter (41) a permanently closed switching element (42) of the switching device (40) is connected to the input terminals (26, 27) of the d.c. voltage amplifier (25), that the common connection point (45) of short-circuiter (41) and permanently closed switching element (42) is connected both to a contact (46) of a further switching element (47) of the switching device (40) and to a terminal point (22) of the output diagonal (21-22) of the measuring bridge (20) and that the other contact (48) of the further switching element (47) is connected on the one hand to the other circuit point (21) of the output diagonal (21-22) of the measuring bridge (20) and on the other hand via an additional switching element (49) of the switching device (40) to that input terminal (26) of the d.c. voltage amplifier (25) which is connected to the short-circuiter (41).

2. A circuit arrangement according to Claim 1,
characterised in that downstream of the d.c voltage amplifier (25) there is arranged an analogue-digital converter (33) which is connected at its output end to a microprocessor (34).

## Revendications

1. Montage pour amplifier un signal (UG) faible de tension continue, comportant un amplificateur (25) de tension continue qui est alimenté de manière périodique à ses bornes (26, 27) d'entrée par un dispositif (40) de connexion, qui comporte un système (41) de court-circuit travaillant de manière périodique, en le signal (UG) de tension continue ou en un signal de référence, et comportant un dispositif (32) d'exploitation des valeurs de mesure qui est monté en aval de l'amplificateur (25) de tension continue, qui enregistre une tension de sortie de l'amplificateur (25) de tension continue obtenue pour le signal de référence à l'entrée (26, 27) de l'amplificateur (25) de tension continue et qui la soustrait d'une tension de sortie de l'amplificateur (25) de tension continue obtenue pour un signal (UG) de tension continue s'appliquant à l'entrée (26, 27) de l'amplificateur (25) de tension continue, caractérisé en ce que le signal (UG) de tension continue à amplifier est formé par un signal présent sur la diagonale (21-22) de sortie d'un pont (20) de mesure, en ce qu'il est monté, en série avec le système (41) de court-circuit travaillant de manière périodique, un élément (42) de connexion toujours fermé du dispositif (40) de connexion aux bornes (26, 27) d'entrée de l'amplificateur (25) de tension continue, en ce que le point (45) de liaison commun du système (41) de court-circuit et de l'élément (42) de connexion toujours fermé est relié à la fois à un contact (46) d'un élément (47) de connexion supplémentaire du dispositif (40) de connexion et à un point (22) de raccordement de la diagonale (21-22) de sortie du pont (20) de mesure, et en ce que l'autre contact (48) de l'élément (47) de connexion supplémentaire est relié d'une part à l'autre point (21) de circuit de la diagonale (21-22) de sortie du pont (20) de mesure et, d'autre part, par l'intermédiaire d'un élément (49) de connexion supplémentaire du dispositif (40) de connexion, à la borne (26) d'entrée de l'amplificateur (25) de tension continue reliée au système (41) de court-circuit.

2. Montage suivant la revendication 1, caractérisé en ce qu'il est monté en aval de l'amplificateur (25) de tension continue un convertisseur (33) analogique-numérique, en aval duquel est monté un microprocesseur (34).
